(19) Europäisches Patentamt
European Patent Office
Office européen des brevets

(11) EP 1 744 140 A2

(12) EUROPEAN PATENT APPLICATION

(43) Date of publication:
17.01.2007 Bulletin 2007/03

(51) Int Cl.:
$G01L\ 23/18^{(2006.01)}$  $G01P\ 15/12^{(2006.01)}$
$G01L\ 9/00^{(2006.01)}$  $G01L\ 9/06^{(2006.01)}$
$H01L\ 29/84^{(2006.01)}$  $G01L\ 1/18^{(2006.01)}$
$G01L\ 1/22^{(2006.01)}$  $G01L\ 9/02^{(2006.01)}$

(21) Application number: 06012417.9

(22) Date of filing: 16.06.2006

(84) Designated Contracting States:
AT BE BG CH CY CZ DE DK EE ES FI FR GB GR
HU IE IS IT LI LT LU LV MC NL PL PT RO SE SI
SK TR
Designated Extension States:
AL BA HR MK YU

(30) Priority: 17.06.2005 US 156224

(71) Applicant: Eaton Corporation
Cleveland, Ohio 44114-2584 (US)

(72) Inventors:
• Ford, Greg Edward
Lake Orion
Michigan 48360 (US)
• Hanisko, John-Cyril
Southfield
Michigan 48076 (US)

(74) Representative: Wagner, Karl H.
WAGNER & GEYER
Patentanwälte
Gewürzmühlstrasse 5
80538 München (DE)

(54) **An improved apparatus for correcting electrical signals**

(57) A novel electrical circuit is disclosed that corrects for at least one undesired characteristic in an incoming electrical signal. In one embodiment, the apparatus reduces the number of wires heretofore required to correct electrical signals in a circuit. The apparatus also corrects for one or more of a second-order error in a measurement, an offset drift can be directly corrected during operation, and a span can be linearized during operation.

FIGURE 2B

**Description**

**BACKGROUND**

*1. Field of the Invention*

This disclosure generally relates to apparatus and methods for measuring and conditioning electronic circuits, and specifically to apparatus and methods for correcting electrical signals in electric circuits.

*2. Related Art*

Piezoresistors are typically used in a Wheatstone bridge circuit. Typically, four piezoresistors are coupled, and use either constant-voltage excitation or a constant-current excitation. As is well known, piezoresistors are resistors that vary their resistance value in response to an applied strain.

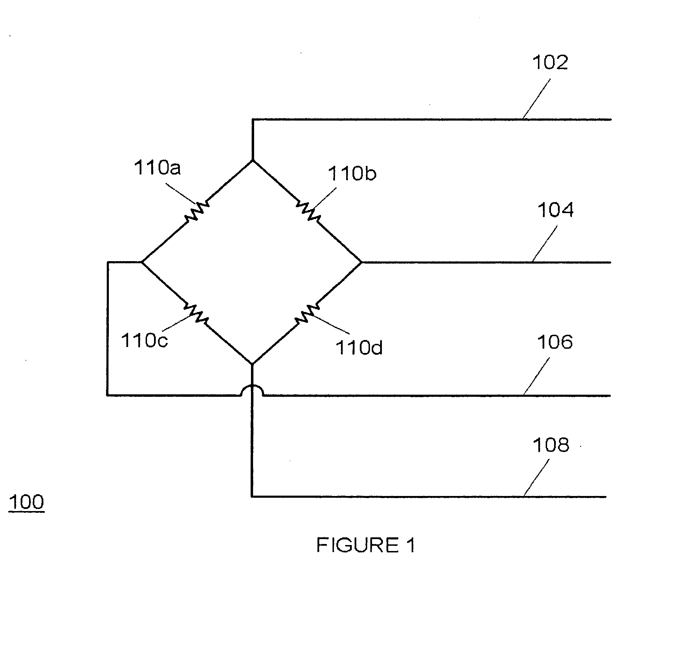

FIGURE 1 shows a Wheatstone bridge circuit wherein piezoresistors are used in a sensed-parameter transduction scheme. Arranged as a four device Wheatstone bridge, FIGURE 1 shows a first constant voltage ("Vc") excitation path 102 connected to the junction a first piezoresistor 110a and a second piezoresistor 110b. A first "sensed" voltage ("V1") is measured at a first sense wire 106. The first sense wire 106 is connected to the junction of the first piezoresistor 110a and a third piezoresistor 110c. A second "sensed" voltage ("V2") is measured at a second sense wire 104. The second sense wire 104 is connected to the junction of the second piezoresistor 110b and a fourth piezoresistor 110d. A return path is provided to the sensed-parameter transduction scheme via a return path wire 108, which is connected to the junction of the third piezoresistor 110c and the fourth piezoresistor 110d. Although FIGURE 1 is described herein as a constant voltage excitation scheme, those skilled in the electronics art appreciate that the circuit illustrated in FIGURE 1 can readily be adapted for use in a constant current excitation scheme. In this configuration, the constant voltage excitation path 102 is replaced with a constant current ("Ic") excitation path. In some embodiments, the piezoresistors 110a, 110b, 110c, and 110d have approximately identical values.

A full four wire Wheatstone bridge exhibits immunity to noise. Common-mode noise coupled into the first sense wire 106 and the second sense wire 104 can be cancelled using well-known noise cancellation techniques. In the embodiments wherein all piezoresistors 110a, 110b, 110c, and 110d have identical resistance, *(i.e.,* 110a = 110b = 110c = 110d = Ro), a variation in a sensed parameter, which causes a change in resistance ($\pm\Delta$Ro), in the piezoresistors 110a, 110b, 110c, and 110d, causes a differential voltage to appear between the first sense wire 106 and the second sense wire 104. This differential voltage is proportional to the variation in the sensed parameter. For a constant voltage excitation, the differential voltage has a value of Vc$\Delta$. For a constant current excitation, the differential voltage has a value of Ic$\Delta$Ro.

A differential voltage which exists in the absence of a variation in the sensed parameter is commonly referred to as an "offset" voltage. This offset is typically removed by "paralleling" selected piezoresistors with trimmable (non-piezo) resistors and then production-trimming one or more of the resistors until the offset is zeroed. Although this technique provides good correction of an initial offset, it disadvantageously introduces higher-order error terms into response signals. The differential voltage becomes VccX($\Delta$ + higher order terms), for constant voltage excitation, and Ic($\Delta$Ro + higher order terms), for constant current excitation. Further, this trim-resistor technique cannot be used to make corrections to offset drifts that occur during operation, nor can it be used to correct for span drift. Furthermore, this technique cannot linearize the response of the bridge.

Therefore, the need exists for an apparatus and method that corrects undesired signal characteristics in an electric circuit. The teachings provide such an apparatus.

**SUMMARY**

An improved apparatus for correcting undesired signal characteristics in an electrical circuit is disclosed. In one embodiment, a multi-wire sensing bridge circuit is disclosed. In this embodiment, a first impedance element and a second impedance element are arranged to sense an incoming signal and subsequently correct for at least one of a plurality of potential undesired signal characteristics.

**BRIEF DESCRIPTION OF THE DRAWINGS**

Embodiments of the present disclosure are more readily understood by reference to the following figures, in which like reference numbers and designations indicate like elements.

FIGURE 1 is a schematic diagram of a piezoresistor Wheatstone bridge having a constant excitation.

FIGURE 2A illustrates a schematic diagram of a multi-wire harness half-bridge circuit of the present teachings.

FIGURE 2B illustrates a schematic diagram of a multi-wire harness half-bridge in accordance with the present teachings.

## DETAILED DESCRIPTION

The present teachings disclose an improved method and circuit for correcting undesired characteristics in an incoming electrical signal.

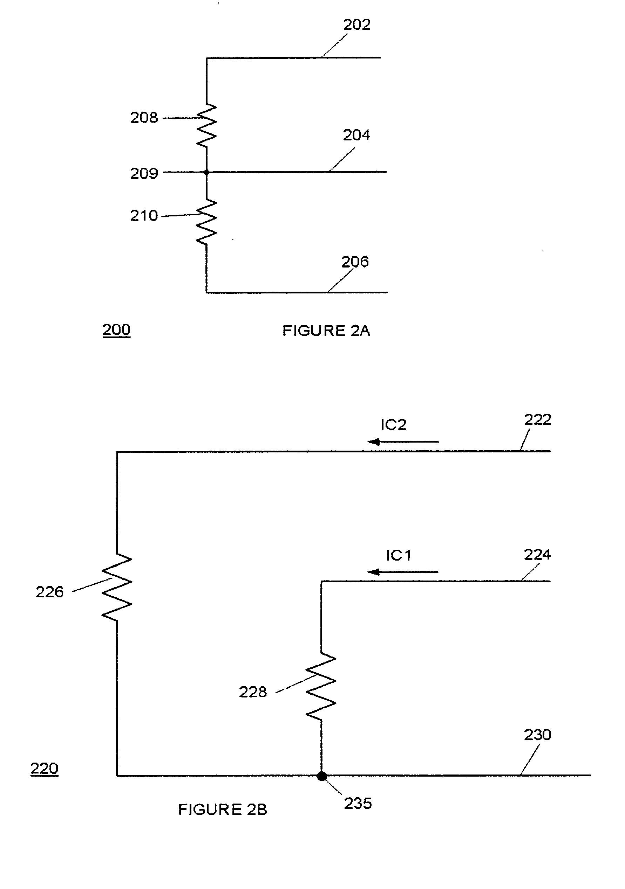

An improved multi-wire sensing bridge circuit is illustrated in FIGURE 2A. In one embodiment, the improved multi-wire sensing bridge comprises an exemplary three wire "half-bridge" circuit. In one embodiment, the multi-wire sensing bridge is adapted to sense an incoming electrical signal and correct undesired characteristics associated with the incoming electrical signal.

In the embodiment shown in FIGURE 2A, a first electrically conductive wire 202 is connected to a first impedance element 208. A second electrically conductive wire 204 is connected to the junction of the first impedance element 208 and a second impedance element 210, at a node 209. A return path is electrically connected to the second impedance element 210 via a third electrically conductive wire 206. In some embodiments, the first impedance element 208 and the second impedance element 210 comprise piezoresistors.

Referring now to FIGURE 2B, an improved multi-sensing bridge circuit is shown. A first current Ic1 conducts through a first wire 224 to a first impedance element 228 and to a return path wire 230. A second current Ic2 conducts through a second wire 222 through a second impedance element 226 and to the return path wire 230. The first wire 224 has an associated and corresponding first excitation and a first sensed parameter when the improved multi-sensing bridge 220 is in operation. The second wire 222 has an associated and corresponding second excitation and a second sensed parameter associated therewith when the improved multi-sensing bridge 220 is in operation. The first impedance element 228 and the second impedance element 226 are connected to the return path wire 230 at a node 235. The first wire 224 and the second wire 222 comprise both excitation lines and sensed parameter lines. The impedance elements 228 and 226 are excited by separate, independent current sources, Ic1 and Ic2, via the lines 224, 222, respectively.

The half-bridge circuits shown in FIGURES 2A and 2B advantageously reduce the number of excitation/sensed parameter wires required to correct undesired electrical signal characteristics. Typically, for example, in a Wheatstone bridge, four wires are required. However, only three such wires are required in the circuits of FIGURES 2A and 2B.

The first wire 224 has a first voltage ("V1") associated therewith. Similarly, the second wire 222 has a second voltage ("V2") associated therewith. In one embodiment, wherein the impedance elements 226, 228 comprise piezoresistors, the differential voltage is defined by the following equation:

$$\text{Eq. 1: } V2-V1 = (Ic2)*(Ro2) - (Ic1)*(Ro1);$$

Wherein Ro1 comprises a resistance value associated with the first impedance element 228 and Ro2 comprises a resistance value associated with the second impedance element 226.

If Ro1 equals Ro2, for Ic1=Ic2, the measured offset is zero.

If the sensed parameters are at their reference zero for the first impedance element 228, Ro1 = Ro1(0), and second impedance element 226, Ro2 = Ro2(0), are not exactly equal, but differ by an amount, "r", such that Ro2(0) = Ro 1 (0) - r = Ro(0) - r. And if Ic1 = Ic2 = Ic, then V2-V1 will be offset from zero by an amount V2(0) - V1(0) = -Ic * r.

An offset in the sensed parameters can be corrected, straightforwardly, by adjusting Ic2(0) such that Ic2(0) = [Ro(0) / (Ro(0) - r)] * Ic1(0) = [V1(0) / V2(0)] * Ic(0).

An adjusted offset ADJ[V2(0) - V1(0)] then becomes ADJ[V2(0) - V1(0)] = {[[Ic(0)] * [Ro(0)]] / [Ro(0) - r]} * [Ro(0) - r] - (Ico(0)) * (Ro(0)) = 0.

If a variation in the sensed parameters of an incoming electrical signal causes Ro2 = Ro2(0)(1 + δ) and Ro1 = Ro1(0) * (1 - δ), then the result is:

$$V2 - V1 = \{[[Ic(0)] * Ro(0)]] / Ro(0) - r\} * [Ro(0) - r] * [1 + \delta] - [Ic(0)] * R(0) * (1 - \delta) = 2 * Ic(0) * Ro(0) * \delta$$

This expression gives a simple, linear relationship between V2 - V1 and δ, with higher-order error terms (e.g.,

second order error terms) absent. As such, the improved multi-wire sensing bridge advantageously eliminates higher-order terms from a measurement of the sensed parameters.

If $\delta$ varies with temperature ("T"), according to a known, or detectable linear or non-linear pattern, $\delta(T) = (1 + B(T)) * \delta$, then the bridge can be corrected directly for span drift by modifying Ic1 and Ic2, each by a factor, $(1 + B(T))^{-1}$. Span drift is caused by two main factors; changes in temperature and sensor deterioration.

The foregoing description illustrates exemplary implementations, and novel features, of aspects of an apparatus for correcting undesired characteristic associated with an incoming electrical signal. Alternative implementations are suggested, but it is impractical to list all alternative implementations of the apparatus. Therefore, the scope of the presented disclosure should be determined only by reference to the appended claims, and should not be limited by features illustrated in the foregoing description except insofar as such limitation is recited in an appended claim.

While the above description has pointed out novel features of the present disclosure as applied to various embodiments, the skilled person will understand that various omissions, substitutions, permutations, and changes in the form and details of the methods and systems illustrated may be made without departing from the scope of the present teachings.

Each practical and novel combination of the elements and alternatives described hereinabove, and each practical combination of equivalents to such elements, is contemplated as an embodiment of the present teachings. Because many more element combinations are contemplated as embodiments of the present teachings than can reasonably be explicitly enumerated herein, the scope of the present teachings is properly defined by the appended claims rather than by the foregoing description. All variations coming within the meaning and range of equivalency of the various claim elements are embraced within the scope of the corresponding claim. Each claim set forth below is intended to encompass any apparatus or method that differs only insubstantially from the literal language of such claim, as long as such apparatus or method is not, in fact, an embodiment of the prior art. To this end, each described element in each claim should be construed as broadly as possible, and moreover should be understood to encompass any equivalent to such element insofar as possible without also encompassing the prior art. Furthermore, to the extent that the term "includes" is used in either the detailed description or the claims, such term is intended to be inclusive in a manner similar to the term "comprising."

## Claims

1. An improved multi-wire sensing bridge apparatus, adapted to correct undesired characteristics associated with an incoming electrical signal incident upon the improved multi-wire sensing bridge, the apparatus comprising:

   a) a multi-wire harness, having a plurality of electrically conductive wires, wherein the multi-wire harness is electrically connected to;
   b) a first impedance element, wherein the first impedance element has a first impedance element value, a first impedance element excitation side, and a first impedance element return side, wherein the first impedance element excitation side is operatively coupled to the incoming incident electrical signal incident upon the improved multi-wire sensing bridge, and wherein the first impedance element return side is operatively coupled to a return path, and;
   c) a second impedance element, wherein the second impedance element has a second impedance element value, a second impedance element excitation side, and a second impedance element return side, wherein the second impedance element excitation side is operatively coupled to the incoming incident electrical signal incident upon the improved multi-wire sensing bridge, and wherein the second impedance element return side is operatively coupled to the return path.

2. The improved multi-wire sensing bridge apparatus as recited in Claim 1, wherein the multi-wire harness comprises a three wire harness.

3. The improved multi-wire sensing bridge apparatus as recited in Claim 2, wherein the first impedance element and the second impedance element comprise piezoresistors.

4. The improved multi-wire sensing bridge apparatus as recited in Claim 3, wherein the first impedance element and the second impedance element have approximately equal impedance values.

5. The improved multi-wire sensing bridge apparatus as recited in Claim 4, wherein the first impedance element excitation side and the second impedance element excitation side share a common return path node.

**6.** The improved multi-wire sensing bridge apparatus as recited in Claim 5, further adapted to avoid second-order errors in a measurement in the incoming electrical signal.

**7.** The improved multi-wire sensing bridge apparatus as recited in Claim 5, further adapted to correct for an offset drift in the incoming electrical signal.

**8.** The improved multi-wire sensing bridge apparatus as recited in Claim 5, further adapted to correct for a span drift in the incoming electrical signal.

**9.** The improved multi-wire sensing bridge apparatus as recited in Claim 5, further adapted to linearize a response of the improved multi-wire sensing bridge.

FIGURE 1

200  FIGURE 2A

220

FIGURE 2B